# EUROPEAN PATENT APPLICATION

(11) **EP 4 701 076 A1**
(43) Date of publication of application: **25.02.2026**
(21) Application number: 25196635.4
(22) Date of filing: 19.08.2025
(51) Int. Cl.: H03H 1/00, H03H 7/42

(54) **INTEGRATING AND/OR COMBINING EMI FILTERS WITH POWER LINES**

(30) Priority: 21.08.2024 CN 202411154723
(71) Applicant: Steward (Foshan) Magnetics Co., Ltd., Foshan, Guangdong 528322 (CN)
(72) Inventor: CHEN, Ye, Foshan City (CN); ZHANG, Jacken, Foshan City (CN); CHIANG, Yeat Shing, Forshan City (CN)
(74) Representative: Lind Edlund Kenamets Intellectual Property AB

(57) **Abstract**

Exemplary embodiments are disclosed of circuits for integrating and/or combining electromagnetic interference, EMI, filters with power lines without using capacitors. In exemplary embodiments, a circuit (320) comprises a common mode inductor (324) including first (328) and second inductors (332). The first inductor (328) is configured to be operable for providing a first impedance along a live wire (336) of the circuit (320). The second inductor (332) is configured to be operable for providing a second impedance along a neutral wire (340) of the circuit (320). The circuit (320) further includes a third inductor (344) configured to be operable for providing a third impedance along a ground wire (348) of the circuit (344).

## Description

### FIELD

The present disclosure relates to integrating and/or combining EMI (Electromagnetic Interference) filters with power lines.

### BACKGROUND

This section provides background information related to the present disclosure which is not necessarily prior art.

EMI filters are configured to reduce or eliminate electromagnetic interference that can affect the performance of electronic equipment. EMI filters typically combine several components including common mode chokes and capacitors.

The capacitors in the EMI filter help to deal with differential mode noise between the lines of the circuit. The common mode choke of the EMI filter is configured to block, attenuate, or filter out common mode noise, which is unwanted signals or interference that appears on both the positive and negative lines of a circuit.

Generally, the common mode choke includes a coil or winding with multiple turns of wire around a magnetic core. The magnetic core material and winding configuration are designed to create a high impedance to common mode noise while allowing the desired or intended signals (differential mode signals) to pass through with minimal attenuation. The high impedance may be achieved by using magnetic core materials with high permeability. Differential mode signals are the normal intended signals that travel in opposite directions through the conductors, while common mode signals travel in the same direction through the conductors.

The common mode choke helps to suppress interference that can disrupt the proper functioning of an electronic device and/or cause the electronic device to emit unwanted noise. By filtering out unwanted noise, the common mode choke helps maintain signal integrity and reliability, *e.g.,* in communication and power systems, *etc.* And by improving the overall EMI performance, EMI filters including common mode chokes can help ensure that electronic equipment complies with regulatory standards and operates reliably.

### DRAWINGS

The drawings described herein are for illustrative purposes only of selected embodiments and not all possible implementations and are not intended to limit the scope of the present disclosure.
FIG. 1 illustrates an EMI filter assembly according to an exemplary embodiment of the present disclosure.
FIG. 2 illustrates a conventional EMI filtering circuit including capacitors for connecting the EMI filter to the power lines.
FIG. 3 illustrates an exemplary embodiment of an EMI filtering circuit including a high impedance inductor along the ground wire (PE) configured such that the EMI filter is integrated, combined, and/or connected with the power lines without using capacitors.
FIG. 4 illustrates a coil or winding disposed along two opposite sides of a magnetic core via a new method according to an exemplary embodiment of the present disclosure.
FIG. 5 is a line graph of insertion loss (IL) in decibels (dB) versus frequency in megahertz (MHz) measured for the common mode signal passing through the common mode inductor and measured for the common mode signal passing through the high-impedance inductor of a prototype EMI filter assembly having the EMI filtering circuit shown in FIG. 3 and the magnetic core and the coil shown in FIG. 4.

Corresponding reference numerals may indicate corresponding (though not necessarily identical) parts throughout the several views of the drawings.

### DETAILED DESCRIPTION

Example embodiments will now be described more fully with reference to the accompanying drawings.

Many EMI filters are assembled with common mode inductors and Y capacitors. And additional power cords are needed to use the EMI filters. As recognized herein, it would be beneficial to provide a safer and more convenient method of using EMI filters.

After recognizing the above, exemplary embodiments were developed and/or are disclosed herein of EMI filtering circuits and assemblies including the same. In exemplary embodiments, EMI filters are integrated, combined, and/or connected with power lines by using high impedance inductors thereby eliminating the need to use capacitors to connect the EMI filters with the power lines.

In exemplary embodiments, a high impedance inductor is added along the ground wire of an EMI filtering circuit. And the capacitors Cx and Cy conventionally used to connect an EMI filter to the ground wire and ground (PE) are eliminated or removed. In such exemplary embodiments, the common mode signal passes through first and second inductors of a common mode inductor along L and N respectively, and then passes through the high-impedance inductance along the ground wire to the input PE. In exemplary embodiments, a coil or winding *(e.g.,* electrically-conductive wire, *etc.)* is disposed along *(e.g.,* wound around, *etc.)* two opposite sides of a magnetic core *(e.g.,* iron toroid core, ferrite toroid core, magnetic ring, *etc.)* via a unique coil winding method.

Advantageously, exemplary embodiments disclosed herein provide an effective solution for an EMI filter and tower line integration scheme that is easy to use and that effectively solves EMI problems. The exemplary methods of combining EMI filters and power lines disclosed herein helps ensure convenient and reliable use by the end user. As disclosed herein, the EMI filters are connected without capacitors and with low leakage current, such that the EMI filters are suitable for safer applications for the human body. Additional advantages of the unique common mode inductor assembly disclosed herein may further include a new compact integrated EMI filter structure, easy processing, and ability to withstand high insulation and voltage resistance.

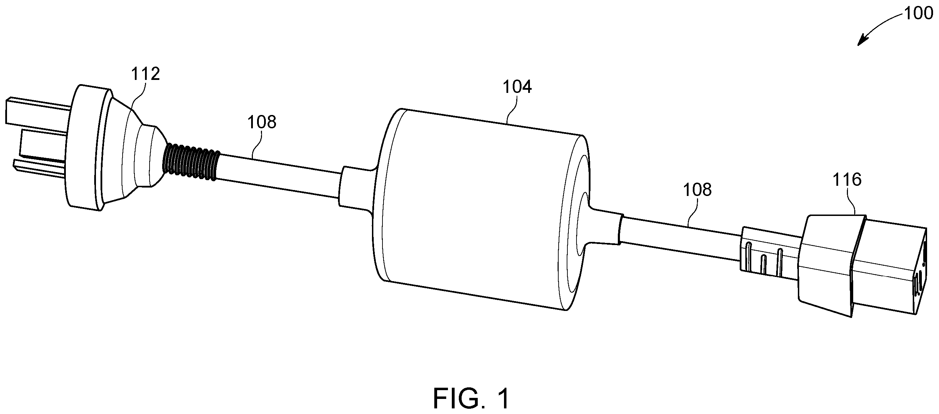

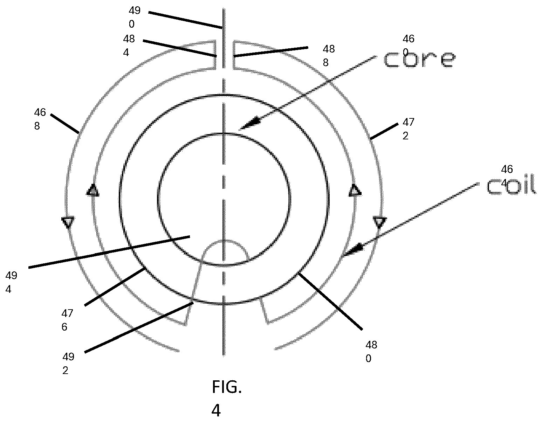

With reference to the figures, FIG. 1 illustrates an EMI filter assembly 100 according to an exemplary embodiment of the present disclosure. As shown in FIG. 1, the EMI filter assembly 100 includes a housing 104 *(e.g.,* plastic shell, *etc.)* in which are located a magnetic core and a coil or winding. The coil or winding may comprise electrically-conductive wire disposed along *(e.g.,* wound around, *etc.)* two opposite sides of the magnetic core *(e.g.,* iron toroid core, ferrite toroid core, magnetic ring, *etc.)* as shown in FIG. 4.

The EMI filter assembly 100 further includes a power cord 108 with first and second end portions 112, 116 extending outwardly from opposite first and second ends of the housing 104. The first and second end portions 112, 116 of the power cord 108 are configured to allow a user to easily connect *(e.g.,* plug and play, *etc.)* the EMI filter assembly 100 between a power source *(e.g.,* an electrical outlet, *etc.)* and an electronic device. In this exemplary embodiment, the first end portion 112 of the power cord 108 includes prongs or terminals that may be plugged into an electrical outlet. The second end portion 116 of the power cord 108 includes receptacles for receiving the prongs or terminals of a power cord from an electronic device.

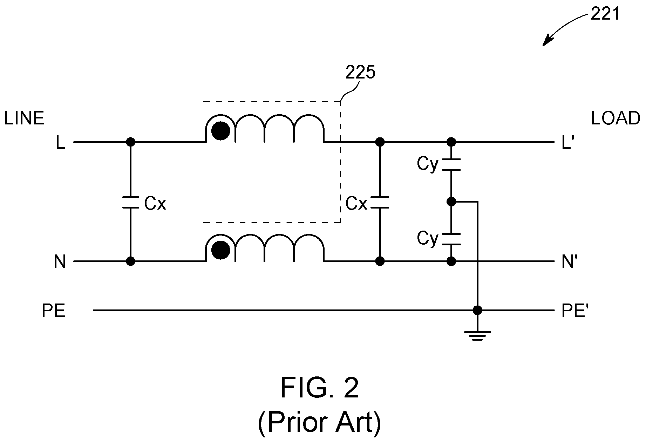

FIG. 2 illustrates a conventional EMI filtering circuit 221 that includes two capacitors Cx in parallel, two capacitors Cy in series, and a common mode inductor 225. The common mode inductor 225 includes two inductors in parallel respectively along the L and N wires. In this conventional EMI filtering circuit 221, the common mode signal passes through the two inductors of the common mode inductor 225 along the respective L and N wires and then passes through the respective capacitors Cy to the ground (PE).

In FIG. 2, L (line or live) represents the live or hot wire that carries electrical current from the power source to the load. The L wire is usually at a high voltage relative to the neutral wire and ground wire. N (neutral) represents the wire that completes the circuit by carrying electrical current away from the load and back to the power source. The N wire is usually at or near ground potential, which is why the N wire is often referred to as "neutral". PE (protective earth or ground) is a safety feature to help protect against electrical shock and ensure that exposed electrically-conductive parts of an installation are safely earthed. The ground wire is connected to the earth ground and provides a path for fault currents to safely dissipate.

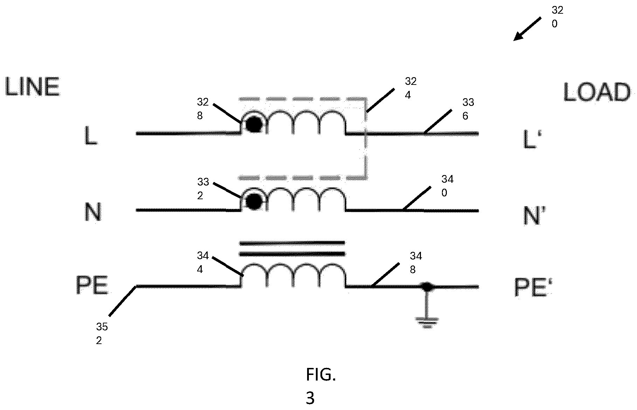

FIG. 3 illustrates an EMI filtering circuit 320 according to an exemplary embodiment of the present disclosure. As shown in FIG. 3, the EMI filtering circuit 320 comprises a common mode inductor 324 including first and second inductors 328, 332. The first inductor 328 is operable for providing a first impedance or inductive reactance along the L (line or live) wire 336. Th second inductance 332 is operable for providing a second impedance or inductive reactance along the N (neutral) wire 340.

The EMI filtering circuit 320 further includes a third or high impedance inductor 344 is operable for providing a third impedance or inductive reactance along the ground wire (PE) 348. The EMI filtering circuit 320 is configured *(e.g.,* via the third inductor 344, *etc.)* is configured such that the EMI filter 320 is integrated, combined, and/or connected with the power lines without using capacitors. The third inductor 344 may be configured such that the third impedance provided by the third inductor 344 along the ground wire 348 is higher than both the first impedance provided by the first inductor 328 along the L (line or live) wire 336 and the second impedance provided by the second inductor 332 along the N (neutral) wire 340. Alternatively, the third inductor 344 may be configured such that the third impedance provided by the third inductor 344 along the ground wire 348 is less than either or both of the first impedance provided by the first inductor 328 along the L (line or live) wire 336 and the second impedance provided by the second inductor 332 along the N (neutral) wire 340.

As compared to the conventional EMI filtering circuit 221 shown in FIG. 2, the EMI filtering circuit 320 (FIG. 3) does not include the two capacitors Cx and two capacitors Cy. The EMI filtering circuit 320 includes the high impedance inductor 344 at about a middle of the ground wire 348. During operation, the EMI filtering circuit 320 is configured such that a common mode signal will pass through the first and second inductors 328, 332 of the common mode inductor 324 that are respectively along the L and N wires 336, 340. The common mode signal will then pass through the high impedance inductor 344 along the ground wire 348 to the input (PE) 352.

Advantageously, the EMI filtering circuit 320 (FIG. 3) is configured to avoid large leakage current that could otherwise be caused by increasing capacitance of the capacitors Cy of the conventional EMI filtering circuit 221 (FIG. 2). The EMI filtering circuit 320 (FIG. 3) can also be configured to comply with and satisfy strict safety requirements. Additionally, the independent high impedance inductor 344 can enhance the ability of the EMI filtering circuit 320 to suppress common mode interference signals when the impedance of the high impedance inductor 344 is less than the ground resistance.

FIG. 4 illustrates a magnetic core 460 *(e.g.,* iron toroid core, ferrite toroid core, magnetic ring, *etc.)* and a coil or winding 464 *(e.g.,* electrically-conductive wire, *etc.).* The coil 464 is disposed along *(e.g.,* wound around, *etc.)* two opposite sides of the magnetic core 460 via a new method *(e.g.,* new coil winding method, *etc.)* according to an exemplary embodiment of the present disclosure.

As shown in FIG. 4, the coil 464 includes first and second coil portions 468, 472 respectively disposed along opposite first and second outer perimeter (*e.g*., circumferential, semi-circular, *etc.)* side portions 476, 480 of the magnetic core 460. Each of the first and second coil portions 468, 472 include at least one turn 484, 488, respectively, adjacent to a bisector or line 490 along the diameter that passes through the center of the circular shape of the magnetic core 460.

The coil 460 also includes a third coil portion 492 connected with and/or between the first and second coil portions 468, 472. The third coil portion 492 passes through an opening 494 *(e.g.,* center circular opening, *etc.)* of the magnetic core 460. The third coil portion 492 crosses over the bisector or line 490 along the diameter that passes through the center of the circular shape of the magnetic core 460.

In order to meet the attenuation of clutter signals in different frequency bands, the configuration of the magnetic core 460 *(e.g.,* size, material, shape, *etc.),* the configuration of the coil 464 *(e.g.,* size, material, number of turns, cross-sectional shape, wire gauge, *etc.),* and/or the winding method can be adjusted. For example, the number of turns of the coil 464 may be increased to increase inductance, which can improve attenuation of higher frequencies in filtering applications and affect impedance matching. Or, for example, the size of the magnetic core 460 may be increased, which larger core may provide increased inductance, reduced core losses, higher saturation flux density, better thermal management and reduced leakage inductance.

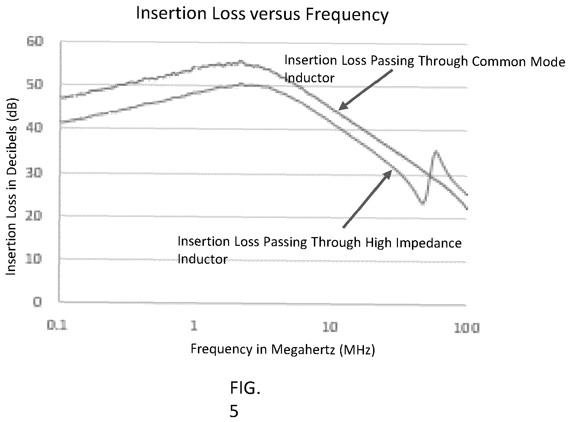

FIG. 5 is a line graph of insertion loss (IL) in decibels (dB) versus frequency in megahertz (MHz) measured for the common mode signal passing through the common mode inductor and measured for the common mode signal passing through the high-impedance inductor of a prototype EMI filter assembly having the EMI filtering circuit 320 shown in FIG. 3 and the magnetic core and coil configuration shown in FIG. 4. Generally, FIG. 5 shows the attenuation values of interference signals at different frequencies.

Disclosed herein are exemplary embodiments circuits for integrating and/or combining electromagnetic interference (EMI) filters with power lines ( *e.g.,* live wires, neutral wires, ground wires, *etc.).* In exemplary embodiments, a circuit comprises a common mode inductor including first and second inductors. The first inductor is configured to be operable for providing a first impedance along a live wire of the circuit. The second inductor is configured to be operable for providing a second impedance along a neutral wire of the circuit. The circuit further includes a third inductor configured to be operable for providing a third impedance along a ground wire of the circuit.

In exemplary embodiments, the circuit is configured such that during operation, a common mode signal will pass through the first and second inductors of the common mode inductor that are respectively along the live wire and neutral wire and then pass through the third inductor along the ground wire.

In exemplary embodiments, the circuit is configured, via the third inductor, to integrate and/or combine an EMI filter with the live wire, the neutral wire, and the ground wire of the circuit without using capacitors. And the circuit does not include any capacitors.

In exemplary embodiments, the third inductor is configured to be operable for providing the third impedance along the ground wire that is higher than the first impedance provided by the first inductor along the live wire and that is also higher than the second impedance provided by the second inductor along the neutral wire.

In exemplary embodiments, the third inductor is configured to be operable for providing the third impedance along the ground wire that is less than ground resistance of the circuit. In such exemplary embodiments, the third inductor may thus enhance the ability of the circuit to suppress common mode interference signals when the third impedance provided by the third inductor along the ground wire is less than the ground resistance of the circuit.

In exemplary embodiments, the first inductor is configured to be operable for providing the first impedance along the live wire of the circuit such that the first impedance is within a range from about 100 ohms to 20000 ohms. The second inductor is configured to be operable for providing the second impedance along the neutral wire of the circuit such that the second impedance is within a range from about 100 ohms to 20000 ohms. And the third inductor is configured to be operable for providing the third impedance along the ground wire of the circuit such that the third impedance is within a range from about 100 ohms to 30000 ohms.

In exemplary embodiments, an EMI filter comprises a circuit as disclosed herein. The EMI filter may include a magnetic core and a coil. The coil may include first, second, and third coil portions. The first and second coil portions may be respectively disposed along opposite first and second outer perimeter side portions of the magnetic core. And the third coil portion may be between the first and second coil portions and pass through an opening of the magnetic core. Each of the first and second coil portions may include at least one turn adjacent to a bisector line along a diameter that passes through a center of the magnetic core. And the third coil portion may cross over the bisector line along the diameter that passes through the center of the magnetic core.

Also disclosed are exemplary methods of integrating and/or combining an electromagnetic interference (EMI) filters with power lines *(e.g.,* live wires, neutral wires, ground wires, *etc.)* without using capacitors. In exemplary embodiments, the method comprises providing or configuring a third inductor of a circuit to be operable for providing a third impedance along a ground wire of the circuit, wherein the circuit includes a common mode inductor including a first inductor configured to be operable for providing a first impedance along a live wire of the circuit, and a second inductor configured to be operable for providing a second impedance along a neutral wire of the circuit.

In exemplary embodiments, the method includes providing or configuring the third inductor such that a common mode signal will pass through the first and second inductors of the common mode inductor that are respectively along the live wire and the neutral wire and then pass through the third inductor along the ground wire.

In exemplary embodiments, the method includes integrating and/or combining an EMI filter with the live wire, the neutral wire, and the ground wire without using capacitors.

In exemplary embodiments, the method includes providing or configuring the third inductor such that the third inductor is operable for providing the third impedance along the ground wire that is higher than the first impedance provided by the first inductor along the live wire and that is also higher than the second impedance provided by the second inductor along the neutral wire. In alternative embodiments, the third inductor may be configured to be operable for providing the third impedance along the ground wire that is less than either or both of the first impedance provided by the first inductor along the live wire and the second impedance provided by the second inductor along the neutral wire.

In exemplary embodiments, the method includes providing or configuring the third inductor such that the third inductor is operable for providing the third impedance along the ground wire that is less than ground resistance to thereby enhance suppression of common mode interference signals.

In exemplary embodiments, the method include positioning first and second coil portions of a coil respectively along opposite first and second outer perimeter side portions of a magnetic core. In such exemplary embodiments, the method further includes positioning a third coil portion of the coil, which is between the first and second coil portions, through an opening of the magnetic core. The method may also include providing each said first and second coil portion with at least one turn adjacent to a bisector line that is along and/or aligned with the magnetic core's diameter. The method may further include positioning the third coil portion through the opening of magnetic coil such that the third coil portion crosses the bisector line that is along and/or aligned with the magnetic core's diameter.

In exemplary embodiments, an electromagnetic interference (EMI) filter comprises a magnetic core and a coil. The magnetic core includes opposite first and second outer perimeter side portions and an opening. And the coil includes first and second coil portions respectively disposed along the opposite first and second outer perimeter side portions of the magnetic core; and a third coil portion between the first and second coil portions that passes through the opening of the magnetic core.

In exemplary embodiments, each of the first and second coil portions includes at least one turn adjacent to a bisector line that is along and/or aligned with the magnetic core's diameter. And the third coil portion is positioned through the opening of the magnetic coil such that the third coil portion crosses the bisector line that is along and/or aligned with the magnetic core's diameter.

In exemplary embodiments, the EMI filter is configured to be operable with an insertion loss greater than 20 decibels for frequencies from 0.1 megahertz to 100 megahertz.

In exemplary embodiments, the EMI filter includes a circuit configured to integrate and/or combine the EMI filter with power lines without using capacitors. The circuit may comprise a common mode inductor including a first inductor along a live wire of the circuit and a second inductor along a neutral wire of the circuit. The circuit may comprise a third inductor along a ground wire of the circuit. The first inductor may be configured to be operable for providing a first impedance along the live wire of the circuit. The second inductor may be configured to be operable for providing a second impedance along the neutral wire of the circuit. And the third inductor may be configured to be operable for providing a third impedance along the ground wire of the circuit.

In exemplary embodiments, the EMI filter is configured such that during operation, a common mode signal will pass through the first and second inductors of the common mode inductor that are respectively along the live wire and the neutral wire and then pass through the third inductor along the ground wire. The EMI filter may be configured to be operable with an insertion loss greater than 20 decibels for frequencies from 0.1 megahertz to 100 megahertz as the common mode signal passes through the common mode inductor and then passes through the third inductor.

In exemplary embodiments, the third inductor is configured to be operable for providing the third impedance along the ground wire that is higher than the first impedance provided by the first inductor along the live wire and that is also higher than the second impedance provided by the second inductor along the neutral wire. In alternative embodiments, the third inductor may be configured to be operable for providing the third impedance along the ground wire that is less than either or both of the first impedance provided by the first inductor along the live wire and the second impedance provided by the second inductor along the neutral wire.

In exemplary embodiments, the third inductor is configured to be operable for providing the third impedance along the ground wire that is less than ground resistance of the circuit.

Example embodiments are provided so that this disclosure will be thorough and will fully convey the scope to those who are skilled in the art. Numerous specific details are set forth such as examples of specific components, devices, and methods, to provide a thorough understanding of embodiments of the present disclosure. It will be apparent to those skilled in the art that specific details need not be employed, that example embodiments may be embodied in many different forms, and that neither should be construed to limit the scope of the disclosure. In some example embodiments, well-known processes, well-known device structures, and well-known technologies are not described in detail. In addition, advantages and improvements that may be achieved with one or more exemplary embodiments of the present disclosure are provided for purpose of illustration only and do not limit the scope of the present disclosure, as exemplary embodiments disclosed herein may provide all or none of the above mentioned advantages and improvements and still fall within the scope of the present disclosure.

Specific numerical dimensions and values, specific materials, and/or specific shapes disclosed herein are example in nature and do not limit the scope of the present disclosure. The disclosure herein of particular values and particular ranges of values for given parameters are not exclusive of other values and ranges of values that may be useful in one or more of the examples disclosed herein. Moreover, it is envisioned that any two particular values for a specific parameter stated herein may define the endpoints of a range of values that may be suitable for the given parameter (the disclosure of a first value and a second value for a given parameter may be interpreted as disclosing that any value between the first and second values could also be employed for the given parameter). For example, if Parameter X is exemplified herein to have value A and also exemplified to have value Z, it is envisioned that parameter X may have a range of values from about A to about Z. Similarly, it is envisioned that disclosure of two or more ranges of values for a parameter (whether such ranges are nested, overlapping, or distinct) subsume all possible combination of ranges for the value that might be claimed using endpoints of the disclosed ranges. For example, if parameter X is exemplified herein to have values in the range of 1 - 10, or 2 - 9, or 3 - 8, it is also envisioned that Parameter X may have other ranges of values including 1 - 9, 1 - 8, 1 - 3, 1 - 2, 2 - 10, 2 - 8, 2 - 3, 3 - 10, and 3 - 9.

The terminology used herein is for the purpose of describing particular example embodiments only and is not intended to be limiting. As used herein, the singular forms "a", "an" and "the" may be intended to include the plural forms as well, unless the context clearly indicates otherwise. The terms "comprises," "comprising," "includes," "including," "has," "have," and "having," are inclusive and therefore specify the presence of stated features, integers, steps, operations, elements, and/or components, but do not preclude the presence or addition of one or more other features, integers, steps, operations, elements, components, and/or groups thereof. The method steps, processes, and operations described herein are not to be construed as necessarily requiring their performance in the particular order discussed or illustrated, unless specifically identified as an order of performance. It is also to be understood that additional or alternative steps may be employed.

When an element or layer is referred to as being "on", "engaged to", "connected to" or "coupled to" another element or layer, it may be directly on, engaged, connected, or coupled to the other element or layer, or intervening elements or layers may be present. In contrast, when an element is referred to as being "directly on," "directly engaged to", "directly connected to" or "directly coupled to" another element or layer, there may be no intervening elements or layers present. Other words used to describe the relationship between elements should be interpreted in a like fashion (*e.g*., "between" versus "directly between," "adjacent" versus "directly adjacent," *etc.).* As used herein, the term "and/or" includes any and all combinations of one or more of the associated listed items.

The term "about" when applied to values indicates that the calculation or the measurement allows some slight imprecision in the value (with some approach to exactness in the value; approximately or reasonably close to the value; nearly). If, for some reason, the imprecision provided by "about" is not otherwise understood in the art with this ordinary meaning, then "about" as used herein indicates at least variations that may arise from ordinary methods of measuring or using such parameters. For example, the terms "generally", "about", and "substantially" may be used herein to mean within manufacturing tolerances. Or for example, the term "about" as used herein when modifying a quantity of an ingredient or reactant of the invention or employed refers to variation in the numerical quantity that can happen through typical measuring and handling procedures used, for example, when making concentrates or solutions in the real world through inadvertent error in these procedures; through differences in the manufacture, source, or purity of the ingredients employed to make the compositions or carry out the methods; and the like. The term "about" also encompasses amounts that differ due to different equilibrium conditions for a composition resulting from a particular initial mixture. Whether or not modified by the term "about", the claims include equivalents to the quantities.

Although the terms first, second, third, *etc.* may be used herein to describe various elements, components, regions, layers and/or sections, these elements, components, regions, layers and/or sections should not be limited by these terms. These terms may be only used to distinguish one element, component, region, layer or section from another region, layer, or section. Terms such as "first," "second," and other numerical terms when used herein do not imply a sequence or order unless clearly indicated by the context. Thus, a first element, component, region, layer, or section could be termed a second element, component, region, layer, or section without departing from the teachings of the example embodiments.

Spatially relative terms, such as "inner," "outer," "beneath", "below", "lower", "above", "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" may encompass both an orientation of above and below. The device may be otherwise oriented (rotated 90 degrees or at other orientations) and the spatially relative descriptors used herein interpreted accordingly.

The foregoing description of the embodiments has been provided for purposes of illustration and description. It is not intended to be exhaustive or to limit the disclosure. Individual elements, intended or stated uses, or features of a particular embodiment are generally not limited to that particular embodiment, but, where applicable, are interchangeable and may be used in a selected embodiment, even if not specifically shown or described. The same may also be varied in many ways. Such variations are not to be regarded as a departure from the disclosure, and all such modifications are intended to be included within the scope of the disclosure.

## Claims

1. A circuit for integrating and/or combining an electromagnetic interference (EMI) filter with power lines, the circuit comprising:
a common mode inductor including a first inductor configured to be operable for providing a first impedance along a live wire of the circuit, and a second inductor configured to be operable for providing a second impedance along a neutral wire of the circuit; and
a third inductor configured to be operable for providing a third impedance along a ground wire of the circuit.

2. The circuit of claim 1, wherein the circuit is configured such that during operation, a common mode signal will pass through the first and second inductors of the common mode inductor that are respectively along the live wire and the neutral wire and then pass through the third inductor along the ground wire.

3. The circuit of any preceding claim, wherein the circuit is configured, via the third inductor, to integrate and/or combine an EMI filter with the live wire, the neutral wire, and the ground wire of the circuit without using capacitors.

4. The circuit of any preceding claim, wherein:
the circuit is configured such that during operation, a common mode signal will pass through the first and second inductors of the common mode inductor that are respectively along the live wire and the neutral wire and then pass through the third inductor along the ground wire;
the circuit is configured, via the third inductor, to integrate and/or combine an EMI filter with the live wire, the neutral wire, and the ground wire of the circuit without using capacitors; and
the circuit does not include any capacitors.

5. The circuit of any preceding claim, wherein the third inductor is configured to be operable for providing the third impedance along the ground wire that is higher than the first impedance provided by the first inductor along the live wire and that is also higher than the second impedance provided by the second inductor along the neutral wire.

6. The circuit of any preceding claim, wherein the third inductor is configured to be operable for providing the third impedance along the ground wire that is less than ground resistance of the circuit.

7. The circuit of any preceding claim, wherein:
the first inductor is configured to be operable for providing the first impedance along the live wire of the circuit such that the first impedance is within a range from about 100 ohms to about 20000 ohms;
the second inductor is configured to be operable for providing the second impedance along the neutral wire of the circuit such that the second impedance is within a range from about 100 ohms to about 20000 ohms; and
the third inductor is configured to be operable for providing the third impedance along the ground wire of the circuit such that the third impedance is within a range from about 100 ohms to about 30000 ohms.

8. An EMI filter comprising the circuit of any preceding claim, wherein the EMI filter incudes a magnetic core and a coil, and wherein the coil includes:
first and second coil portions respectively disposed along opposite first and second outer perimeter side portions of the magnetic core; and
a third coil portion between the first and second coil portions that passes through an opening of the magnetic core.

9. The EMI filter of claim 8, wherein:
each said first and second coil portion includes at least one turn adjacent to a bisector line along a diameter that passes through a center of the magnetic core; and
the third coil portion crosses over the bisector line along the diameter that passes through the center of the magnetic core.

10. The EMI filter of claim 8 or 9, wherein the EMI filter is configured to be operable with an insertion loss greater than 20 decibels for frequencies from 0.1 megahertz to 100 megahertz.

11. The EMI filter of any one of claims 8 to 10, wherein:
the EMI filter is configured such that during operation, a common mode signal will pass through the first and second inductors of the common mode inductor that are respectively along the live wire and the neutral wire and then pass through the third inductor along the ground wire; and
the EMI filter is configured to be operable with an insertion loss greater than 20 decibels for frequencies from 0.1 megahertz to 100 megahertz as the common mode signal passes through the common mode inductor and then passes through the third inductor.

12. An electromagnetic interference (EMI) filter comprising:
a magnetic core including opposite first and second outer perimeter side portions and an opening; and
a coil including:
first and second coil portions respectively disposed along the opposite first and second outer perimeter side portions of the magnetic core; and
a third coil portion between the first and second coil portions that passes through the opening of the magnetic core.

13. The EMI filter of claim 12, wherein:
each said first and second coil portion includes at least one turn adjacent to a bisector line along a diameter that passes through a center of the magnetic core; and
the third coil portion crosses over the bisector line along the diameter that passes through the center of the magnetic core.

14. The EMI filter of claim 12 or 13, wherein the EMI filter includes a circuit configured to integrate and/or combine the EMI filter with power lines without using capacitors, and wherein the circuit comprises:
a common mode inductor including a first inductor configured to be operable for providing a first impedance along a live wire of the circuit, and a second inductor configured to be operable for providing a second impedance along the neutral wire of the circuit; and
a third inductor configured to be operable for providing a third impedance along a ground wire of the circuit.

15. The EMI filter of claim 14, wherein:
the EMI filter is configured such that during operation, a common mode signal will pass through the first and second inductors of the common mode inductor that are respectively along the live wire and the neutral wire and then pass through the third inductor along the ground wire; and
the third inductor is configured to be operable for providing the third impedance along the ground wire that is:
higher than the first impedance provided by the first inductor along the live wire;
higher than the second impedance provided by the second inductor along the neutral wire; and
less than ground resistance of the circuit.
